# EUROPÄISCHE PATENTSCHRIFT

(11) **EP 2 764 554 B1**
(45) Veröffentlichungstag und Bekanntmachung des Hinweises auf die Patenterteilung: **08.08.2018**
(21) Anmeldenummer: 12753446.9
(22) Anmeldetag: 16.08.2012
(51) Int. Cl.: H01L 33/50

(54) **OPTOELEKTRONISCHES HALBLEITERBAUELEMENT UND MODUL MIT EINER MEHRZAHL VON DERARTIGEN BAUELEMENTEN**
OPTOELECTRONIC SEMICONDUCTOR DEVICE AND MODULE COMPRISING A PLURALITY OF SUCH DEVICES
DISPOSITIF SEMICONDUCTEUR OPTOELECTRONIQUE ET MODULE AYANT PLUSIEURS DE CES DISPOSITIFS

(30) Priorität: 20.09.2011 DE 102011113802
(43) Veröffentlichungstag der Anmeldung: 13.08.2014
(73) Patentinhaber: OSRAM Opto Semiconductors GmbH, 93055 Regensburg (DE)
(72) Erfinder: STOLL, Ion, 93105 Tegernheim (DE); PETERSEN, Kirstin, 93053 Regensburg (DE)
(74) Vertreter: Epping - Hermann - Fischer
(86) Internationale Anmeldenummer: PCT/EP2012/066037
(87) Internationale Veröffentlichungsnummer: WO 2013/041314

(56) Entgegenhaltungen:
- EP-A2- 2 339 655
- WO-A1-2007/080555
- US-A1- 2006 244 358
- US-A1- 2009 015 137
- US-A1- 2010 224 895
- US-A1- 2011 049 550

## Beschreibung

Optoelektronisches Halbleiterbauelement und Modul mit einer Mehrzahl von derartigen Bauelementen Die Erfindung betrifft ein optoelektronisches Bauelement, das einen Halbleiterchip, einen ersten und einen zweiten Konverter umfasst. Weiter betrifft die vorliegende Erfindung ein Modul mit einer Mehrzahl derartiger Halbleiterbauelemente.

Die Druckschrift US 2008/0187746 beschreibt ein optoelektronisches Bauelement. Die Druckschrift EP 2339655 beschreibt ein optoelektronisches Halbleiterbauelement mit einem ersten und einem zweiten Wellenlängenkonverter. Es ist Aufgabe der vorliegenden Erfindung, ein optoelektronisches Halbleiterbauelement anzugeben, das zur Hinterleuchtung geeignet ist und eine maximale Helligkeit und gleichzeitig einen vergrößerten Farbgamut aufweist, wobei ein geringer Produktionsaufwand notwendig ist.

Die Erfindung betrifft ein optoelektronisches Halbleiterbauelement gemäß Patentanspruch 1.

Gemäß der Erfindung umfasst das optoelektronische Halbleiterbauelement einen Halbleiterchip, wobei der Halbleiterchip eine zur Strahlungserzeugung geeignete aktive Schicht aufweist, die geeignet ist, Strahlung im blauen Wellenlängenbereich zu emittieren. Zum Beispiel handelt es sich bei dem Halbleiterchip um einen Laserdiodenchip oder einen Leuchtdiodenchip.

Dem Halbleiterchip ist in Abstrahlrichtung ein erster Konverter nachgeordnet, der eine Ce-Dotierung umfasst, und dem Halbleiterchip ist in Abstrahlrichtung ein zweiter Konverter nachgeordnet, der eine Ce-Dotierung von höchstens 1,5 % umfasst, wobei der erste Konverter eine höhere Ce-Dotierung als der zweite Konverter aufweist.

Die Konverter umfassen zum Beispiel je einen Leuchtstoff, der in ein Matrixmaterial eingebettet sein kann. Der Leuchtstoff kann aber auch als Vollkörper vorliegen. Der entsprechende Konverter besteht dann aus dem Leuchtstoff. Ferner ist es möglich, dass der Leuchtstoff in Form von Partikeln vorliegt, die im Matrixmaterial verteilt sind. Der Leuchtstoff weist die Dotierung mit Ce auf. Bei dem Matrixmaterial kann es sich zum Beispiel um Glas, keramisches Material oder ein Kunststoffmaterial wie Silikon handeln.

Durch den zweiten Konverter mit reduzierter Ce-Dotierung kann vorteilhafterweise das von dem Halbleiterbauelement emittierte Emissionsspektrum an die Augenempfindlichkeit des menschlichen Auges optimiert werden. Das Absorptionsspektrum des zweiten Konverters verändert sich dabei durch die Reduzierung der Ce-Dotierung nur geringfügig. Durch den ersten Konverter mit hoher Ce-Dotierung kann der Farbgamut beziehungsweise der Farbort der emittierten Strahlung mit Vorteil optimiert werden. Durch eine Kombination des ersten Konverters und des zweiten Konverters kann insbesondere insgesamt ein großer Farbraum abgedeckt werden, wobei das Emissionsspektrum gleichzeitig auf die Augenempfindlichkeit und einen geeigneten Farbort optimiert ist. Insgesamt kann so eine maximale Helligkeit erzielt werden, ohne dass Verluste durch unterschiedliche Absorptionseigenschaften der Konverter auftreten. Zudem ist mit Vorteil keine Nachsteuerung bei unterschiedlichen Anregungswellenlängen von unterschiedlichen, produktgleichen Halbleiterchips notwendig, wodurch sich vorteilhafterweise der Produktionsaufwand reduziert.

Unter dem "Farbort" werden im Folgenden insbesondere die Zahlenwerte verstanden, die die Farbe des emittierten Lichts der Halbleiterchips oder des Halbleiterbauelements im CIE-Farbraum beschreiben.

Der "CIE-Farbraum" ist insbesondere das CIE-Norm-Valenz-System (auch bekannt unter CIE 1931). Dem CIE-Norm-Valenz-System werden Messwerte zugrunde gelegt, die auf einen Normalbeobachter bezogen sind und die in einer CIE-Norm-Farbtafel darstellbar sind. Die Fläche möglicher Farben ist bei der CIE-Norm-Farbtafel auf einem Koordinatensystem aufgetragen, auf dem der x-Anteil und y-Anteil einer beliebigen Farbe direkt abgelesen werden kann.

Gemäß der Erfindung weist der erste Konverter eine Dominanzwellenlänge in einem Bereich zwischen einschließlich 565 nm und einschließlich 575 nm auf, und der zweite Konverter weist eine Dominanzwellenlänge in einem Bereich zwischen einschließlich 550 nm und einschließlich 560 nm auf. Die Dominanzwellenlängen sind dabei vorteilhaft derart ausgewählt, dass der erste Konverter zur Korrektur des Farborts und der zweite Konverter zur Anpassung an die Augenempfindlichkeit des menschlichen Auges ausgewählt ist. Der zweite Konverter deckt dabei einen großen Farbraum ab und emittiert bei einer Dominanzwellenlänge, die auf die Augenempfindlichkeit optimiert ist. Der erste Konverter dagegen wird lediglich zur Korrektur des Farborts verwendet, sodass das Halbleiterbauelement bevorzugt für Hinterleuchtungszwecke geeignet ist. Das Halbleiterbauteil ist dabei insbesondere zur Hinterleuchtung eines LCD-Panels geeignet. So kann insgesamt eine maximale Helligkeit erzielt werden, ohne dass Verluste durch unterschiedliche Absorptionseffekte auftreten und ohne dass ein erhöhter Produktionsaufwand wegen einer Nachsteuerung bei unterschiedlichen Anregungswellenlängen notwendig ist.

Gemäß zumindest einer Ausführungsform umfasst das optoelektronische Halbleiterbauelement einen Halbleiterchip, der eine zur Strahlungserzeugung geeignete aktive Schicht aufweist, die geeignet ist, Strahlung im blauen Wellenlängenbereich zu emittieren. Dem Halbleiterchip ist in Abstrahlrichtung ein erster Konverter nachgeordnet, der eine Ce-Dotierung von wenigstens 2,5 %, insbesondere wenigstens 3 %, bevorzugt wenigstens 4 % umfasst. Zudem ist dem Halbleiterchip in Abstrahlrichtung ein zweiter Konverter nachgeordnet, der eine Ce-Dotierung von höchstens 1,5 %, insbesondere von höchstens 1 % umfasst.

Vorzugsweise weisen der erste Konverter und der zweite Konverter ein identisches oder nahezu identisches Absorptionsspektrum auf. Dadurch kann eine bestehende Konvertermischung aus erstem Konverter und zweitem Konverter für eine Vielzahl von unterschiedlichen produktgleichen Halbleiterchips, die ein unterschiedliches Emissionsspektrum aufweisen, ohne eine zwangsläufig notwendige Anpassung verwendet werden, wobei die Konvertermischung dabei mit Vorteil gleichzeitig auf die Helligkeit, den Farbraum und den Farbgamut optimiert ist. Zudem kann eine erhöhte Helligkeit in der Augenempfindlichkeit bei einem unverändert großen Farbraum erzeugt werden.

Bevorzugt wird ein Emissionsspektrum des Bauelements realisiert, das sich aus einer Superposition der einzelnen emittierten beziehungsweise konvertierten Spektren des Halbleiterchips beziehungsweise der Konverter zusammensetzt, und das vorteilhafterweise an die herkömmlichen LCD-Filtersysteme abgestimmt ist. Dadurch ermöglicht sich eine maximale Helligkeit und ein vergrößerter Farbgamut zur Hinterleuchtung von beispielsweise Bildschirmen.

Der erste und der zweite Konverter sind dem Halbleiterchip in Abstrahlrichtung nachgeordnet. Dabei kann beispielsweise der erste Konverter direkt auf einer Strahlungsauskoppelfläche des Halbleiterchips aufgebracht sein, wobei der zweite Konverter direkt auf dem ersten Konverter aufgebracht ist. In diesem Fall ist somit der erste Konverter zwischen Halbleiterchip und zweitem Konverter angeordnet. Entsprechend kann der zweite Konverter zwischen Halbleiterchip und erstem Konverter angeordnet sein. Alternativ können der erste Konverter und der zweite Konverter nebeneinander auf der Strahlungsauskoppelfläche des Halbleiterchips angeordnet sein. In diesem Fall tritt die von dem Halbleiterchip emittierte Strahlung entweder durch den ersten Konverter oder durch den zweiten Konverter. Weiter alternativ können der erste Konverter und der zweite Konverter miteinander vermischt und ineinander integriert sein, sodass der erste Konverter und der zweite Konverter nicht als separate Schicht ausgebildet sind.

Das Halbleiterbauelement ist ein optoelektronisches Bauelement, das die Umwandlung von elektrisch erzeugten Daten oder Energien in Lichtemission ermöglicht oder umgekehrt. Das Halbleiterbauelement weist zumindest einen optoelektronischen Halbleiterchip auf, vorzugsweise einen strahlungsemittierenden Halbleiterchip. Der Halbleiterchip ist bevorzugt eine LED (Licht emittierende Diode), besonders bevorzugt eine Dünnfilm-LED. Bei Dünnfilm-LEDs ist insbesondere ein Aufwachssubstrat, auf dem Schichten des Halbleiterchips epitaktisch aufgewachsen worden sind, teilweise oder vollständig abgelöst worden. Der Halbleiterchip weist einen Halbleiterschichtenstapel auf, in dem die aktive Schicht enthalten ist. Die aktive Schicht enthält vorzugsweise einen pn-Übergang, eine Doppelheterostruktur, eine Einfachquantentopfstruktur (SQW, single quantum well) oder eine Mehrfachquantentopfstruktur (MQW, multi quantum well) zur Strahlungserzeugung. Die Bezeichnung Quantentopfstruktur entfaltet hierbei keine Bedeutung hinsichtlich der Dimensionalität der Quantisierung. Sie umfasst unter anderem Quantentröge, Quantendrähte und Quantenpunkte und jede Kombination dieser Strukturen.

Der Halbleiterschichtenstapel des Halbleiterchips enthält vorzugsweise ein III/V-Halbleitermaterial. III/V-Halbleitermaterialien sind zur Strahlungserzeugung im ultravioletten, über den sichtbaren bis in den infraroten Spektralbereich besonders geeignet.

Gemäß zumindest einer Ausführungsform konvertiert der erste Konverter einen Teil der von dem Halbleiterchip emittierten Strahlung in Strahlung im gelben und/oder gelb-orangen Wellenlängenbereich. Vorzugsweise konvertiert der zweite Konverter einen Teil der von dem Halbleiterchip emittierten Strahlung in Strahlung im grünen oder gelbgrünen Wellenlängenbereich.

Der erste und zweite Konverter wandeln demnach beide einen Teil der von dem Halbleiterchip emittierten blauen Strahlung in Strahlung mit einer anderen Wellenlänge um. Insbesondere wird eine Konvertermischung aus einem niedrig Ce-dotierten Konverter mit einem grünlichen Farbort und einem stark Ce-dotierten Konverter mit einem gelblich oder gelb-orangen Farbort verwendet. Dabei wird vorteilhafterweise das optimale Verhältnis zwischen Grünanteil, der zur Steigerung der Helligkeit geeignet ist, und einer breiten

Wellenlängenverteilung des gelben oder gelb-orangen Anteils, der einen möglichst großen Farbraum gewährleistet, eingestellt. Diese Konvertermischung kann mit Vorteil für einen weiten Bereich an Halbleiterchip-Wellenlängen eingesetzt werden, ohne zwangsläufig neu angepasst werden zu müssen.

Vorzugsweise sind der erste und zweite Konverter jeweils geeignet, einen Teil der von dem Halbleiterchip emittierten Strahlung in Strahlung zumindest einer anderen Wellenlänge zu konvertieren. Ein anderer Teil der von dem Halbleiterchip emittierten Strahlung kann unkonvertiert transmittiert werden. Dazu kann der Konverter zum Beispiel ein Matrixmaterial umfassen, das für blaue Strahlung durchlässig ist.

Unkonvertiert transmittiert bedeutet hierbei, dass die von dem Halbleiterchip emittierte Strahlung zumindest anteilig ohne Beeinflussung durch den ersten beziehungsweise zweiten Konverter bleibt, sodass dieser Anteil der Strahlung den Konverter, als blaue Strahlung verlässt. Die Konverter sind demnach nicht zu einer vollständigen Konversion geeignet, sondern konvertieren lediglich einen Teil der von dem Halbleiterchip emittierten Strahlung.

Gemäß zumindest einer Ausführungsform sind der erste Konverter ein YAG- oder TAG-Konverter und der zweite Konverter ein YAG-Konverter. Der erste Konverter weist eine Dominanzwellenlänge in einem Bereich zwischen einschließlich 565 nm und einschließlich 575 nm auf, bevorzugt von 571 nm. Der zweite Konverter weist eine Dominanzwellenlänge in einem Bereich zwischen einschließlich 550 nm und einschließlich 560 nm auf, vorzugsweise von 555 nm.

Die Dominanzwellenlänge oder auch die dominante Wellenlänge wird auch als empfundene Wellenlänge bezeichnet. Sie kennzeichnet die farbtongleiche Wellenlänge, die das menschliche Auge beim Betrachten empfindet.

Die in dieser Anmeldung angegebenen Wellenlängenbereiche der Konverter sind insbesondere Bereiche, in denen der jeweilige Konverter seine Dominanzwellenlänge hat. Das bedeutet, dass das Emissionsspektrum des ersten und zweiten Konverters ebenfalls außerhalb der angegebenen Wellenlängenbereiche einen spektralen Verlauf aufweisen kann, wobei jedoch das Emissionsmaximum jeweils in den angegebenen Bereich fällt.

Gemäß der Erfindung ist die Dominanzwellenlänge des zweiten Konverters an die Augenempfindlichkeit des menschlichen Auges angepasst. Vorzugsweise ist die Dominanzwellenlänge des ersten Konverters zu einer Korrektur des Farborts geeignet. Der zweite Konverter deckt dabei einen großen Farbraum ab und emittiert bei einer Dominanzwellenlänge, die auf die Augenempfindlichkeit optimiert ist. Der erste Konverter dagegen wird lediglich zur Korrektur des Farborts verwendet, sodass das Halbleiterbauelement bevorzugt für Hinterleuchtungszwecke geeignet ist. Das Halbleiterbauteil ist dabei insbesondere zur Hinterleuchtung eines LCD-Panels geeignet. So kann insgesamt eine maximale Helligkeit erzielt werden, ohne dass Verluste durch unterschiedliche Absorptionseffekte auftreten und ohne dass ein erhöhter Produktionsaufwand wegen einer Nachsteuerung bei unterschiedlichen Anregungswellenlängen notwendig ist.

Zur Hinterleuchtung von Bildschirmen wie beispielsweise Fernsehern und Computermonitoren werden oftmals LEDs benutzt, denen in Abstrahlrichtung LCD-Filter nachgeschaltet sind. Dabei gibt es unterschiedliche Anforderungen an die LEDs. Zum einen werden eine maximale Helligkeit der LEDs und zum anderen ein großer Farbgamut erwartet. Durch unterschiedliche Konverter, die den LEDs in Abstrahlrichtung nachgeschaltet sind, können die Eigenschaften der LEDs angepasst werden. Die gewünschten Eigenschaften wie beispielsweise Helligkeit und Farbgamut verhalten sich jedoch meist gegensätzlich zueinander. Beispielsweise weist eine Mischung aus einem grünen und einem roten Konverter nicht die Helligkeit von gelben Konvertern, jedoch einen größeren Farbgamut als gelbe Konverter auf.

Als Anforderungen an die LEDs werden meist ein kalt-weißer Farbort und eine maximale Helligkeit in der Augenwahrnehmung mit einem Farbgamut von etwa 72 % der Fläche bezogen auf den NTSC-Farbraum gewünscht. Meist werden hierzu schmalbandige blau-emittierende Halbleiterchips verwendet, dessen Lichtanteile mittels eines Konverters in Licht im gelben und roten Wellenlängenbereich konvertiert wird, sodass weißes Licht entsteht. Dabei können sich jedoch durch Produktionsschwankungen Abweichungen der Helligkeit und des Farborts der produktgleichen LEDs ergeben. Aufgrund dieser Produktionsschwankungen wird meist nachteilig die Menge des verwendeten Konverters an die jeweilige Wellenlänge und Helligkeit des jeweiligen Halbleiterchips angepasst.

Für Hinterleuchtungen werden häufig YAG-basierte Konverter eingesetzt, beispielsweise ein Y₃Al₅O₁₂:Ce³⁺-basierter oder ein Y₃(Ga_{X}Al_{1-X})O₁₂:Ce³⁺-basierter Konverter. Diese besitzen ein breites Emissionsspektrum, wobei die Emissionswellenlänge eine ausreichende Fläche im Farbraum abdeckt und nahe der Augenempfindlichkeit liegt. Die Helligkeit in Bezug auf die Augenempfindlichkeit kann zusätzlich gesteigert werden, indem ein zweiter Konverter mit einem grünen Farbort hinzugegeben wird. Hierzu eignen sich ein Lu₃Al₅O₁₂:Ce³⁺-basierter oder ein Y₃(Ga_{X}Al₁-_{X})O₁₂:Ce³⁺-basierter Konverter. So kann die Emission auf die Augenempfindlichkeit optimiert werden. Jedoch unterscheiden sich der Yttrium-basierte Konverter und der Lutetium-basierte Konverter in ihren Absorptionsmaxima. Das führt nachteilig dazu, dass für verschiedene Anregungswellenlängen das Verhältnis der Konverter angepasst werden muss, was zu einem erhöhten Produktionsaufwand führt.

Gemäß zumindest einer Ausführungsform sind der erste und/oder zweite Konverter jeweils ein Y₃Al₅O₁₂:Ce³⁺-basierter Konverter.

Gemäß zumindest einer Ausführungsform sind der erste Konverter und/oder der zweite Konverter als Konverterplättchen ausgebildet. Konverterplättchen weisen beispielsweise ein Matrixmaterial mit den darin eingebetteten Leuchtstoffen auf. Mittels beispielsweise eines Layertransfers können die separat hergestellten Konverterplättchen auf die Halbleiterchips aufgebracht werden. Dem Fachmann sind derartige Konverterplättchen auch unter dem Begriff Leuchtstofflayer bekannt.

Gemäß zumindest einer Ausführungsform bilden der erste Konverter und der zweite Konverter eine gemeinsame Konvertermischung aus. Beispielsweise sind der erste Konverter und der zweite Konverter in einem gemeinsamen Matrixmaterial eingebettet. Hierbei bilden vorzugsweise der erste und der zweite Konverter keine separaten Schichten aus, sondern sind miteinander bevorzugt homogen vermischt. Dem Halbleiterchip ist also somit eine Konvertermischung, die beispielsweise als Konverterplättchen ausgebildet ist, in Abstrahlrichtung nachgeordnet, die den ersten und zweiten Konverter umfasst.

Gemäß zumindest einer Ausführungsform umfasst ein Modul eine Mehrzahl von Halbleiterbauelementen umfassend einen Halbleiterchip, einen ersten Konverter und einen zweiten Konverter. Bevorzugt sind die Halbleiterbauelemente auf einem gemeinsamen Trägersubstrat angeordnet. Besonders bevorzugt ist den Halbleiterbauelementen in Abstrahlrichtung ein optisches Element nachgeordnet. Vorzugsweise werden in das optische Element die von dem Halbleiterchip emittierte und die von den Konvertern konvertierte Strahlung eingekoppelt. In dem optischen Element können so die Spektralbestandteile der konvertierten und unkonvertierten Strahlungen gemischt werden, sodass mit Vorteil weißes Licht entsteht.

Gemäß zumindest einer Ausführungsform ist das optische Element ein Lichtleiter. Dieser Lichtleiter ist vorzugsweise zur Hinterleuchtung von Fernsehern und Computermonitoren oder anderen Bildschirmen geeignet. Vorzugsweise ist der Lichtleiter derart ausgebildet, dass eine homogene Abstrahlcharakteristik erzielt wird. Hierzu enthält der Lichtleiter beispielsweise Streuzentren, die bevorzugt geeignet sind, die in den Lichtleiter eingekoppelten Spektralbestandteile homogen in alle Raumrichtungen zu streuen.

Vorzugsweise wird das Modul zur Hinterleuchtung beispielsweise eines Bildschirms verwendet.

Weitere Vorteile und vorteilhafte Weiterbildungen der Erfindung ergeben sich aus den im Folgenden in Verbindung mit den Figuren 1 bis 3 beschriebenen Ausführungsbeispielen. Es zeigen:
- Figuren 1, 2: jeweils einen schematischen Querschnitt eines Ausführungsbeispiels eines erfindungsgemäßen Halbleiterbauelements, und
- Figur 3: einen schematischen Querschnitt eines Ausführungsbeispiels eines erfindungsgemäßen Moduls.

In den Figuren können gleiche oder gleich wirkende Bestandteile jeweils mit den gleichen Bezugszeichen versehen sein. Die dargestellten Bestandteile und deren Größenverhältnisse untereinander sind nicht als maßstabsgerecht anzusehen. Vielmehr können einzelne Bestandteile wie beispielsweise Schichten, Strukturen, Komponenten und Bereiche zur besseren Darstellbarkeit und/oder zum besseren Verständnis übertrieben dick oder groß dimensioniert dargestellt sein.

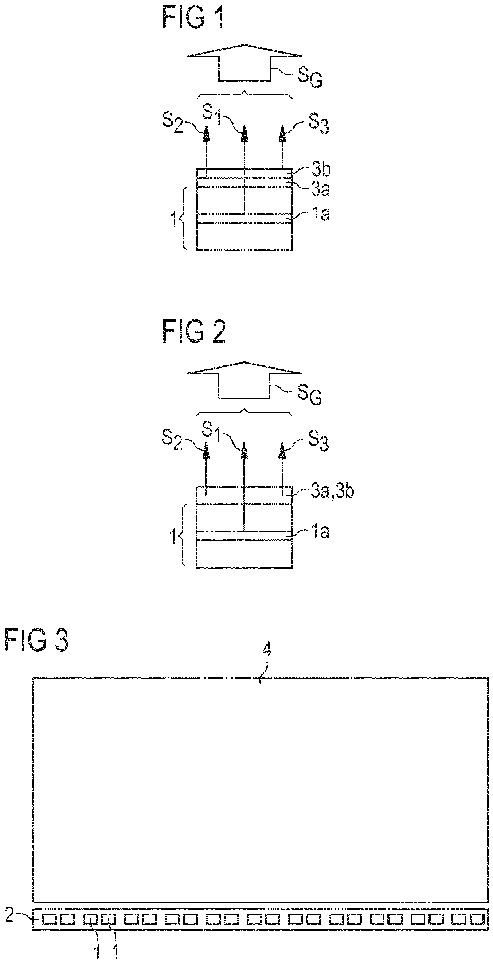

In Figur 1 ist ein Querschnitt eines Ausführungsbeispiels eines Halbleiterbauelements gezeigt, das einen Halbleiterchip 1 aufweist. Der Halbleiterchip 1 weist eine zur Strahlungserzeugung geeignete aktive Schicht 1a auf, die geeignet ist, Strahlung im blauen Wellenlängenbereich zu emittieren. Der Halbleiterchip 1 weist eine Halbleiterschichtenfolge auf, die auf einem III/V-Halbleitermaterial basiert. Die aktive Schicht 1a ist dabei in der Halbleiterschichtenfolge integriert. Der Halbleiterchip 1 ist vorzugsweise eine LED.

Dem Halbleiterchip 1 ist in Abstrahlrichtung ein erster Konverter 3a nachgeordnet, der geeignet ist, Strahlung im blauen Wellenlängenbereich in Strahlung im gelben und/oder gelb-orangen Wellenlängenbereich zu konvertieren. Der erste Konverter 3a umfasst eine Ce-Dotierung von wenigstens 4 %, insbesondere von 4 % oder mehr. Vorzugsweise ist der erste Konverter ein YAG (Yttrium-Aluminiumoxid)- oder ein TAG-Konverter. Der erste Konverter 3a ist insbesondere ein Y₃Al₅O₁₂:Ce³⁺-basierter Konverter. Der erste Konverter 3a weist eine Dominanzwellenlänge in einem Bereich zwischen einschließlich 565 nm und einschließlich 575 nm, bevorzugt 571 nm, auf.

Der erste Konverter 3a ist vorliegend als Konverterplättchen ausgebildet und direkt auf einer Strahlungsauskoppelfläche des Halbleiterchips 1 angeordnet. Hierzu ist beispielsweise das Konverterplättchen 3a separat hergestellt, mittels eines Layertransfers auf den Halbleiterchip 1 übertragen und dort befestigt. Der erste Konverter 3a konvertiert bevorzugt die von dem Halbleiterchip 1 emittierte Strahlung teilweise in Strahlung im gelben und/oder gelb-orangen Wellenlängenbereich. Das bedeutet, dass lediglich eine Teilkonversion im ersten Konverter 3a stattfindet, sodass aus dem ersten Konverter 3a hindurch tretende Strahlen sowohl einen blauen Anteil sowie einen gelben und/oder gelb-orangen Anteil umfassen. Beispielsweise wird bis zu 50 % der von der aktiven Schicht 1a des Halbleiterchips 1 emittierten Strahlung in dem ersten Konverter 3a in gelbe beziehungsweise gelb-orange Strahlung umgewandelt und bis zu 50 % unkonvertiert als blaue Strahlung transmittiert.

Auf dem ersten Konverter 3a ist ein zweiter Konverter 3b angeordnet und damit dem Halbleiterchip 1 in Abstrahlrichtung nachgeordnet, der ebenfalls als Konverterplättchen ausgebildet ist. Der zweite Konverter 3b konvertiert einen Teil der von dem Halbleiterchip 1 emittierten blauen Strahlung in Strahlung im grünen Wellenlängenbereich. Ein Teil der von dem Halbleiterchip 1 emittierten Strahlung wird durch den zweiten Konverter 3b unkonvertiert als blaue Strahlung transmittiert. Zudem wird die vom ersten Konverter 3a konvertierte Strahlung bevorzugt im zweiten Konverter 3b unkonvertiert transmittiert. Aus dem zweiten Konverter 3b hindurch tretende Strahlen umfassen somit sowohl einen gelben und/oder gelb-orangen Anteil der im ersten Konverter 3a konvertierten Strahlung, einen grünen Anteil der im zweiten Konverter 3b konvertierten Strahlung sowie einen blauen Anteil der vom Halbleiterchip 1 emittierten Strahlung. Beispielsweise wird wiederum bis zu 50 % der von der aktiven Schicht 1a des Halbleiterchips 1 emittierten Strahlung in dem zweiten Konverter 3b in grüne Strahlung umgewandelt.

Der zweite Konverter 3b ist wiederum vorzugsweise ein YAGbasierter Konverter, bevorzugt ein Y₃Al₅O₁₂:Ce³⁺-basierter Leuchtstoff. Der zweite Konverter 3b weist insbesondere eine geringe Ce-Dotierung von höchstens 1 % auf. Der zweite Konverter 3b weist eine Dominanzwellenlänge in einem Bereich von einschließlich 550 nm und einschließlich 560 nm, bevorzugt 555 nm, auf.

Die Konverter 3a, 3b weisen jeweils bevorzugt ein Matrixmaterial auf, in dem einzelne Leuchtstoffe eingebettet sind. Besonders bevorzugt sind die einzelnen Leuchtstoffe der Konverter 3a, 3b in dem Matrixmaterial homogen verteilt, sodass eine möglichst homogene Abstrahlcharakteristik erzielt werden kann.

Das Halbleiterbauelement der Figur 1 emittiert insgesamt blaue Strahlung S₁, die von dem Halbleiterchip 1 emittiert und unkonvertiert transmittiert wird, gelbe und/oder gelb-orange Strahlung S₂, die von dem ersten Konverter 3a konvertiert wird, und grüne Strahlung S₃, die von dem zweiten Konverter 3b umgewandelt wird. Dadurch kann ein Bauelement realisiert werden, dessen Emissionsspektrum S_{G} einen vergrößerten Farbraum im Vergleich zu dem einzelnen Halbleiterchip 1 bei maximaler Helligkeit aufweist. Derartige Bauelemente eignen sich dadurch insbesondere zur Hinterleuchtung von Bildschirmen, wie beispielsweise Fernsehern und Computern.

Durch die Verwendung der oben genannten Konverter 3a, 3b kann mit Vorteil ein hoher Farbgamut bei maximaler Helligkeit erzielt werden. Die Kombination des ersten und zweiten Konverters 3a, 3b weist vorteilhafterweise ein optimales Verhältnis zwischen Grünanteil, der die Helligkeit steigert, und einer breiten Wellenlängenverteilung zum Erzielen eines möglichst großen Farbraums auf. Insbesondere ist die Dominanzwellenlänge des zweiten Konverters 3b an die Augenempfindlichkeit optimiert, während der erste Konverter 3a zur Korrektur des Farborts Verwendung findet. So kann eine maximale Helligkeit erzielt werden, ohne dass Verluste durch unterschiedliche Absorptionseffekte an den Konvertern 3a, 3b auftreten. Insbesondere weisen der erste Konverter 3a und der zweite Konverter 3b mit Vorteil ein identisches oder nahezu identisches Absorptionsspektrum auf. Dadurch ist vorteilhafterweise keine Nachsteuerung der Konverter 3a, 3b bei unterschiedlichen Anregungswellenlängen notwendig, was vorteilhafterweise nicht unnötig den Produktionsaufwand erhöht. Insbesondere ist die Kombination des ersten und des zweiten Konverters 3a, 3b auf die Helligkeit und den Farbraum unabhängig der unterschiedlichen, produktgleichen Halbleiterchip-Wellenlänge optimiert.

Das Ausführungsbeispiel der Figur 2 unterscheidet sich von dem Ausführungsbeispiel der Figur 1 dadurch, dass der erste Konverter 3a und der zweite Konverter 3b eine gemeinsame Konvertermischung ausbilden. Beispielsweise sind der erste Konverter 3a und der zweite Konverter 3b in einem gemeinsamen Konverterplättchen integriert und/oder in einem gemeinsamen Matrixmaterial vorzugsweise homogen eingebettet. Auf der Auskoppelseite des Halbleiterchips 1 sind somit keine zwei Konverterplättchen vertikal übereinander aufgebracht, sondern lediglich ein Konverterplättchen mit den integrierten zwei Konvertern.

Im Übrigen stimmt das Ausführungsbeispiel der Figur 2 im Wesentlichen mit dem Ausführungsbeispiel der Figur 1 überein.

In Figur 3 ist ein Ausführungsbeispiel eines Moduls dargestellt, das eine Mehrzahl von Halbleiterbauelementen umfasst, die beispielsweise nebeneinander auf einem Trägersubstrat 2 angeordnet sind. Die Halbleiterbauelemente der Figur 3 können beispielsweise jeweils entsprechend dem Halbleiterbauelement gemäß dem Ausführungsbeispiel der Figur 1 und/oder der Figur 2 ausgestaltet sein. Die Bauelemente weisen demnach jeweils einen Halbleiterchip 1 auf, dem jeweils der erste Konverter 3a und zweite Konverter 3b in Abstrahlrichtung nachgeordnet ist. Die Bauelemente sind auf dem Trägersubstrat bevorzugt nebeneinander in einer Reihe angeordnet.

Den Halbleiterchips 1 der Bauelemente ist in Abstrahlrichtung ein gemeinsames optisches Element 4 nachgeordnet. Das optische Element 4 ist beispielsweise ein Lichtleiter, der bevorzugt Streuzentren enthält. Die Streuzentren sind bevorzugt geeignet, die von den Halbleiterbauelementen emittierte Strahlung homogen in alle Raumrichtungen zu streuen.

Die von dem Halbleiterchip 1 der Halbleiterbauelemente emittierten und die konvertierten Strahlen werden in den gemeinsamen Lichtleiter 4 gemeinsam eingekoppelt, wobei in dem Lichtleiter 4 die Spektralbestandteile der Strahlungen gemischt werden. Insbesondere koppelt die vom Halbleiterchip 1 emittierte blaue Strahlung, die vom ersten Konverter 3a konvertierte gelbe und/oder gelb-orange Strahlung sowie die vom zweiten Konverter 3b konvertierte grüne Strahlung gemeinsam in den Lichtleiter 4 ein und werden dort bevorzugt homogen gemischt. Derartige in einem Lichtleiter eingekoppelte und dort gemischte Strahlen können zur Hinterleuchtung von beispielsweise Fernsehern und Computermonitoren Verwendung finden.

## Patentansprüche

1. Optoelektronisches Halbleiterbauelement, das einen Halbleiterchip (1) umfasst, wobei
- der Halbleiterchip (1) eine zur Strahlungserzeugung geeignete aktive Schicht (1a) aufweist, die geeignet ist, Strahlung im blauen Wellenlängenbereich zu emittieren,
- dem Halbleiterchip (1) in Abstrahlrichtung ein erster Konverter (3a) nachgeordnet ist, der eine Ce-Dotierung umfasst, und
- dem Halbleiterchip (1) in Abstrahlrichtung ein zweiter Konverter (3b) nachgeordnet ist, der eine Ce-Dotierung von höchstens 1,5 % umfasst, wobei
- der erste Konverter (3a) eine höhere Ce-Dotierung als der zweite Konverter (3b) aufweist, wobei
- der erste Konverter (3a) eine Dominanzwellenlänge der vom ersten Konverter (3a) im Betrieb abgestrahlten elektromagnetischen Strahlung in einem Bereich zwischen einschließlich 565 nm und einschließlich 575 nm aufweist, und
- der zweite Konverter (3b) eine Dominanzwellenlänge der vom zweiten Konverter (3b) im Betrieb abgestrahlten elektromagnetischen Strahlung in einem Bereich zwischen einschließlich 550 nm und einschließlich 560 nm aufweist.

2. Halbleiterbauelement nach dem vorherigen Anspruch, wobei der erste Konverter (3a) eine Ce-Dotierung von wenigstens 2,5 % umfasst.

3. Halbleiterbauelement nach einem der vorherigen Ansprüche, wobei der erste Konverter (3a) einen Teil der von dem Halbleiterchip (1) emittierten Strahlung in Strahlung im gelben und/oder gelb-orangen Wellenlängenbereich konvertiert.

4. Halbleiterbauelement nach einem der vorhergehenden Ansprüche,
wobei der zweite Konverter (3b) einen Teil der von dem Halbleiterchip (1) emittierten Strahlung in Strahlung im grünen Wellenlängenbereich konvertiert.

5. Halbleiterbauelement nach einem der vorhergehenden Ansprüche,
wobei der erste Konverter (3a) ein YAG- oder TAG-Konverter und der zweite Konverter (3b) ein YAG-Konverter sind.

6. Halbleiterbauelement nach einem der vorhergehenden Ansprüche,
wobei der erste und/oder zweite Konverter (3a, 3b) ein Y₃Al₅O₁₂:Ce³⁺-basierter Konverter sind.

7. Halbleiterbauelement nach einem der vorhergehenden Ansprüche,
wobei der erste Konverter (3a) und/oder der zweite Konverter (3b) als Konverterplättchen ausgebildet sind.

8. Halbleiterbauelement nach einem der vorhergehenden Ansprüche 1 bis 5,
wobei der erste Konverter (3a) und der zweite Konverter (3b) eine gemeinsame Konvertermischung ausbilden.

9. Modul umfassend eine Mehrzahl von Halbleiterbauelementen nach einem der vorhergehenden Ansprüche.

10. Verwendung eines Moduls nach Anspruch 9 als Hinterleuchtung.

## Claims

1. Optoelectronic semiconductor component comprising a semiconductor chip (1), wherein
- the semiconductor chip (1) has an active layer (1a) suitable for generating radiation and suitable for emitting radiation in the blue wavelength range,
- a first converter (3a) comprising a Ce doping is disposed downstream of the semiconductor chip (1) in the emission direction, and
- a second converter (3b) comprising a Ce doping of at most 1.5% is disposed downstream of the semiconductor chip (1) in the emission direction, wherein
- the first converter (3a) has a higher Ce doping than the second converter (3b), **characterized in that**
- the first converter (3a) has a dominant wavelength of the electromagnetic radiation emitted by the first converter (3a) during operation in a range of between 565 nm and 575 nm inclusive, and
- the second converter (3b) has a dominant wavelength of the electromagnetic radiation emitted by the second converter (3b) during operation in a range of between 550 nm and 560 nm inclusive.

2. Semiconductor component according to the preceding claim,
wherein the first converter (3a) comprises a Ce doping of at least 2.5%.

3. Semiconductor component according to any of the preceding claims,
wherein the first converter (3a) converts a part of the radiation emitted by the semiconductor chip (1) into radiation in the yellow and/or yellow-orange wavelength range.

4. Semiconductor component according to any of the preceding claims,
wherein the second converter (3b) converts a part of the radiation emitted by the semiconductor chip (1) into radiation in the green wavelength range.

5. Semiconductor component according to any of the preceding claims,
wherein the first converter (3a) is a YAG or TAG converter and the second converter (3b) is a YAG converter.

6. Semiconductor component according to any of the preceding claims,
wherein the first and/or second converter (3a, 3b) are/is a Y₃Al₅O₁₂:Ce³⁺-based converter.

7. Semiconductor component according to any of the preceding claims,
wherein the first converter (3a) and/or the second converter (3b) are/is embodied as converter lamina(e).

8. Semiconductor component according to any of the preceding claims 1 to 5,
wherein the first converter (3a) and the second converter (3b) form a common converter mixture.

9. Module comprising a plurality of semiconductor components according to any of the preceding claims.

10. The use of a module according to claim 9 as backlighting.

## Revendications

1. Composant à semi-conducteur optoélectronique, lequel comprend une puce à semi-conducteur (1),
- la puce à semi-conducteur (1) présentant une couche active (1a) adaptée à générer un rayonnement, laquelle couche est apte à émettre un rayonnement dans la plage de longueur d'onde bleue,
- un premier convertisseur (3a), lequel comprend un dopage Ce, étant disposé en aval de la puce à semi-conducteur (1) dans le sens de rayonnement, et
- un deuxième convertisseur (3b), lequel comprend un dopage Ce de maximum 1,5%, étant disposé en aval de la puce à semi-conducteur (1) dans le sens de rayonnement, **caractérisé en ce que**
- le premier convertisseur (3a) présentant un dopage Ce supérieur au deuxième convertisseur (3b), le premier convertisseur (3a) présentant une longueur d'onde de dominance du rayonnement électromagnétique émis en fonctionnement par le premier convertisseur (3a) située dans une plage comprise entre y compris 565 cm et y compris 575 nm, et
- le deuxième convertisseur (3b) présentant une longueur d'onde de dominance du rayonnement électromagnétique émis en fonctionnement par le deuxième convertisseur (3b) située dans une plage comprise entre y compris 550 cm et y compris 560 nm.

2. Composant à semi-conducteur selon la revendication précédente,
le premier convertisseur (3a) comprenant un dopage Ce d'au moins 2,5%.

3. Composant à semi-conducteur selon l'une quelconque des revendications précédentes,
le premier convertisseur (3a) convertissant une partie du rayonnement émis par la puce à semi-conducteur (1) en rayonnement dans la plage de longueur d'onde jaune et/ou jaune-orange.

4. Composant à semi-conducteur selon l'une quelconque des revendications précédentes,
le deuxième convertisseur (3b) convertissant une partie du rayonnement émis par la puce à semi-conducteur (1) en rayonnement dans la plage de longueur d'onde verte.

5. Composant à semi-conducteur selon l'une quelconque des revendications précédentes,
le premier convertisseur (3a) étant un convertisseur YAG ou un convertisseur TAG et le deuxième convertisseur (3b) étant un convertisseur YAG.

6. Composant à semi-conducteur selon l'une quelconque des revendications précédentes,
le premier et/ou le deuxième convertisseurs (3a, 3b) étant un convertisseur basé sur Y₃Al₅0₁₂:Ce³⁺.

7. Composant à semi-conducteur selon l'une quelconque des revendications précédentes,
le premier convertisseur (3a) et/ou le deuxième convertisseur (3b) étant réalisés comme plaquette de convertisseur.

8. Composant à semi-conducteur selon l'une quelconque des revendications précédentes 1 à 5,
le premier convertisseur (3a) et le deuxième convertisseur (3b) formant un mélange de convertisseurs communs.

9. Module comprenant une pluralité de composants semiconducteurs selon l'une quelconque des revendications précédentes.

10. Utilisation d'un module selon la revendication 9 en tant que rétroéclairage.
